# EUROPEAN PATENT APPLICATION

(11) **EP 2 236 553 A1**
(43) Date of publication of application: **06.10.2010**
(21) Application number: 10159115.4
(22) Date of filing: 06.04.2010
(51) Int. Cl.: C08K 9/02, C08K 9/04, C08J 5/18, H01L 21/00

(54) **Metal oxide fine particle-containing silicone resin composition**

(30) Priority: 03.04.2009 JP 2009091243
(71) Applicant: Nitto Denko Corporation, Ibaraki-shi, Osaka 567-8680 (JP)
(72) Inventor: Ozaki, Takashi, Ibaraki-shi Osaka (JP); Fujii, Haruka, Ibaraki-shi Osaka (JP); Katayama, Hiroyuki, Ibaraki-shi Osaka (JP)
(74) Representative: Grünecker, Kinkeldey, Stockmair & Schwanhäusser Anwaltssozietät

(57) **Abstract**

The present invention relates to a metal oxide fine particle-containing silicone resin composition obtained by polymerizing a thermosetting silicone derivative with metal oxide fine particles having reactive functional groups on surfaces thereof, in which the thermosetting silicone derivative contains a compound represented by formula (I): 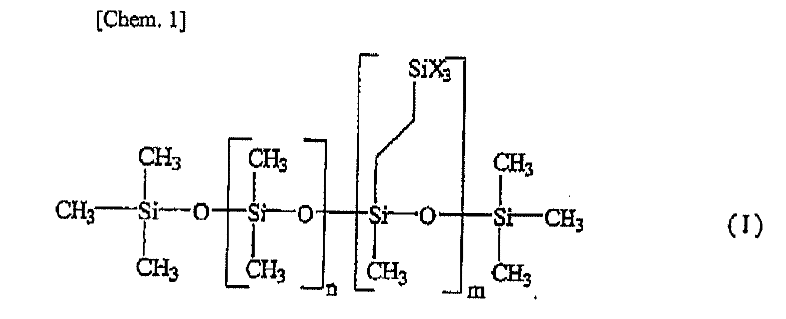 in which X's each independently represent an alkoxy group or an alkyl group, m represents an integer of 1 or more, and n represents an integer of 0 or 1 or more, provided that at least one of 3m X's is an alkoxy group.

## Description

### FIELD OF THE INVENTION

The present invention relates to a metal oxide fine particle-containing silicone resin composition. More particularly, the invention relates to a silicone resin composition which is excellent in transparency, light transmitting property and heat resistance and has a high refractive index, a method for producing the same, a sheet-shaped molded article of the composition, and an optical semiconductor device encapsulated with the composition.

### BACKGROUND OF THE INVENTION

In recent years, attention has been attracted to white light-emitting diodes (LEDs) as new illumination light sources realizing substantial energy conservation. The luminance per chip of LEDs for illumination is extremely high, different from that of LEDs for display. Accordingly, resins for encapsulation thereof are required to have excellent light resistance and heat resistance, in addition to transparency.

In response to this, silicone resins having higher durability than epoxy resins widely used for encapsulation of the LEDs for display have been utilized for encapsulation of the LEDs for illustration. However, the silicone resins generally have a refractive index as low as about 1.4 to cause an increase in the difference from the refractive index (about 2.5) of the chip, thereby increasing all light reflection at an interface between the encapsulating resin and the chip from Snell's law. Accordingly, there is a problem that light extraction efficiency is decreased.

In order to solve this problem, the silicone resins are required to increase the refractive index, while maintaining transparency and heat resistance. As one means therefor, there is proposed, for example, a method of dispersing metal oxide fine particles having a high refractive index and such a minute particle size that light scattering is negligible, in the silicone resin. In order to disperse the metal oxide fine particles having high hydrophilicity in the silicone resin having high hydrophobicity, there is exemplified a method of previously modifying surfaces of the metal oxide fine particles with a silane coupling agent or the like to perform a hydrophobilizing treatment, for example, as shown in JP-A-2008-106186 and JP-A-2007-308345.

### SUMMARY OF THE INVENTION

However, when the refractive index of the silicone resins is increased according to the methods of JP-A-2008-106186 and JP-A-2007-308345, the two-step processes of "surface treatment" and "dispersion" of the metal oxide fine particles are required, and further, a high-speed stirring treatment by using a special device is necessary for the "dispersion." Accordingly, these methods have not been necessarily satisfied in terms of process simplification. Furthermore, the silane coupling agent widely used contains a large amount of reactive functional groups, so that the silicone resin containing the metal oxide fine particles surface-treated with the silane coupling agent is poor in heat resistance.

An object of the invention is to provide a silicone resin composition which is excellent in transparency, light transmitting property and heat resistance and has a high refractive index, a method for producing the same, a sheet-shaped molded article of the composition, and an optical semiconductor device encapsulated with the composition.

Namely, the invention relates to the following (1) to (5).
(1) A metal oxide fine particle-containing silicone resin composition obtained by polymerizing a thermosetting silicone derivative with metal oxide fine particles having reactive functional groups on surfaces thereof, in which the thermosetting silicone derivative contains a compound represented by formula (I): 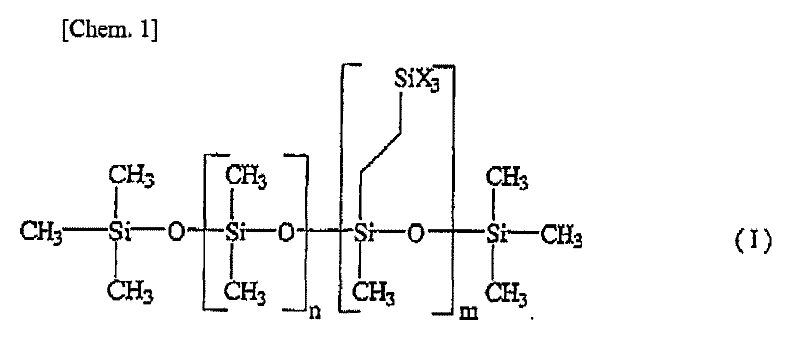 in which X's each independently represent an alkoxy group or an alkyl group, m represents an integer of 1 or more, and n represents an integer of 0 or 1 or more, provided that at least one of 3m X's is an alkoxy group.
(2) The metal oxide fine particle-containing silicone resin composition according to (1), in which the metal oxide fine particles have an average particle size of 1 to 100 nm.
(3) A method for producing a metal oxide fine particle-containing silicone resin composition, the method including a step of polymerizing a thermosetting silicone derivative with metal oxide fine particles having reactive functional groups on surfaces thereof, in which the thermosetting silicone derivative contains a compound represented by formula (I): 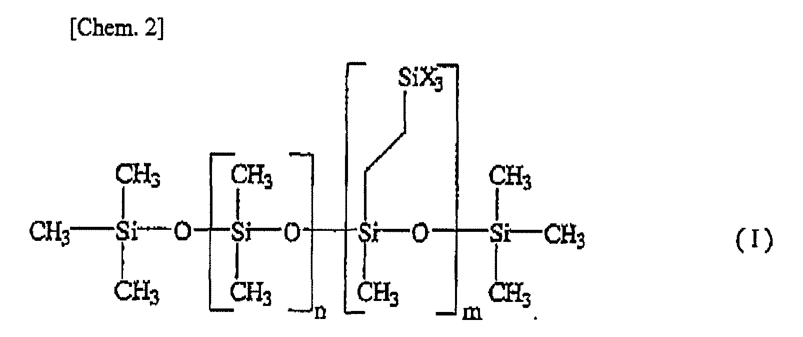 in which X's each independently represent an alkoxy group or an alkyl group, m represents an integer of 1 or more, and n represents an integer of 0 or 1 or more, provided that at least one of 3m X's is an alkoxy group.
(4) A silicone resin sheet formed by applying the metal oxide fine particle-containing silicone resin composition according to (1) or (2) onto a substrate, followed by drying.
(5) An optical semiconductor device in which an optical semiconductor element is encapsulated by the metal oxide fine particle-containing silicone resin composition according to (1) or (2) or the silicone resin sheet according to (4).

The metal oxide fine particle-containing silicone resin composition of the invention achieves an effect of being excellent in transparency, light transmitting property and heat resistance and having a high refractive index.

### DETAILED DESCRIPTION OF THE INVENTION

The metal oxide fine particle-containing silicone resin composition of the invention (hereinafter also referred to as the silicone resin composition of the invention) is a metal oxide fine particle-containing silicone resin composition obtained by polymerizing a thermosetting silicone derivative with metal oxide fine particles having reactive functional groups on surfaces thereof, in which the above-mentioned thermosetting silicone derivative contains a compound (hereinafter also referred to as an alkoxy group-containing polymethylsiloxane in the invention) represented by formula (I):

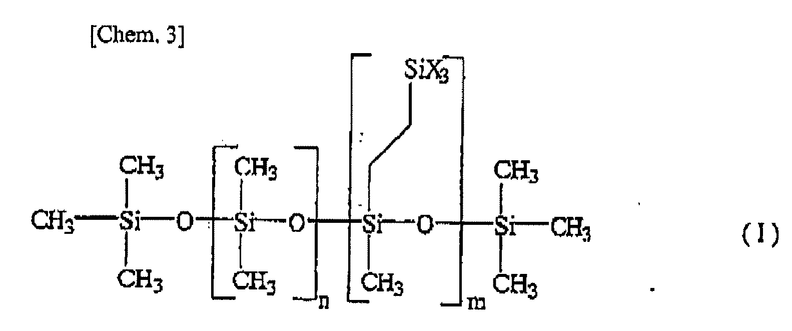

in which X's each independently represent an alkoxy group or an alkyl group, m represents an integer of 1 or more, and n represents an integer of 0 or 1 or more, provided that at least one of 3m X's is an alkoxy group.

In the invention, there are used the specific compound having alkoxy groups on a skeleton of the silicone resin constituting the silicone resin composition and the metal oxide fine particles having reactive functional groups on surfaces thereof. The alkoxy group of the silicone resin and the reactive functional group of the metal oxide fine particles are reacted with each other to cause chemical bonding of both, resulting in the presence of the metal oxide fine particles on the silicone resin through the bonding. This method only requires that the silicone resin and the metal oxide fine particles are reacted with each other, compared to the method of surface-treating the metal oxide fine particles with the silane coupling agent, and then, dispersing the metal oxide fine particles in the silicone resin. Accordingly, the refractive index of the silicone resin can be simply increased without necessity of the special device and without through the two-step processes of "surface treatment" and "dispersion".

Further, X's in formula (I) each independently represent an alkoxy group or an alkyl group, provided that at least one of 3m X's is an alkoxy group. Accordingly, no reactive functional group is present in the compound represented by formula (I), except for the alkoxy group of X, so that heat resistance does not become impaired.

The carbon number of the alkoxy group is preferably from 1 to 4, and more preferably 1 or 2, from the viewpoints of reactivity on the surfaces of the metal oxide fine particles and the hydrolysis rate. Specifically, there are exemplified a methoxy group, an ethoxy group and the like. On the other hand, the carbon number of the alkyl group is preferably from 1 to 18, more preferably from 1 to 12, and still more preferably from 1, to 6, from the viewpoints of hydrophilicity/hydrophobicity control on the surfaces of the metal oxide fine particles, polycondensation reaction efficiency of the alkoxysilane, and the like. Specifically, there are exemplified a methyl group, an ethyl group, a propyl group, an isopropyl group and the like.

As X₃, there are exemplified a trimethoxy group, a dimethoxymethyl group, a methoxydimethyl group, a triethoxy group, a diethoxyethyl group, an ethoxydiethyl group and the like. Of these, a trimethoxy group, a dimethoxymethyl group and a triethoxy group are preferred from the viewpoints of transparency and heat resistance.

m in formula (I) represents an integer of 1 or more, and preferably an integer of 1 to 50 and more preferably an integer of 1 to 20, from the viewpoints of reactivity and compatibility with the metal oxide fine particles.

n in formula (I) represents an integer of 0 or 1 or more, and preferably an integer of 0 to 30 and more preferably an integer of 0 to 20, from the viewpoints of reactivity and compatibility with the metal oxide fine particles.

Examples of compounds represented by such formula (I) include a trimethoxy group-containing polymethylsiloxane, a dimethoxymethyl group-containing polymethylsiloxane and a triethoxy group-containing polymethylsiloxane, and these may be used either alone or as a combination of two or more thereof.

The molecular weight of the compound represented by formula (I) is preferably from 300 to 13,000, and more preferably from 300 to 6,000, form the viewpoints of stability and handling properties. Incidentally, in this specification, the molecular weight of the silicone derivative is measured by gel permeation chromatography (GPC).

Further, the alkoxy group content is preferably 10% by weight or more, and more preferably from 14 to 60% by weight, per molecule of the compound represented by formula (I). Incidentally, in this specification, the alkoxy group content can be found from quantitative determination by ¹H-NMR and the weight decrease by heating.

As the compound represented by formula (I), which is used in the invention, there may be used a compound synthesized by a known method or a commercially available compound. However, the compound can be synthesized by a method shown below.

Specifically, a side chain type methyl hydrogen silicone oil is added dropwise to a mixture of an alkoxy group-containing vinylsilane, a catalyst and a compatibilizer, followed by mixing preferably at a temperature of less than 90°C, and thereafter, a reaction is performed under a nitrogen atmosphere as needed, thereby obtaining the compound. Incidentally, the reaction product thus obtained may be concentrated under reduced pressure.

Examples of the alkoxy group-containing vinylsilane include trimethoxyvinylsilane, dimethoxyvinylsilane, methoxyvinylsilane, triethoxyvinylsilane, diethoxyvinylsilane and ethoxyvinylsilane, and these may be used either alone or as a combination of two or more thereof.

The catalyst may be any as long as it catalyzes an addition reaction of a vinyl group of the alkoxy group-containing vinylsilane and a hydrosilyl group of the side chain type methyl hydrogen silicone oil. There are exemplified platinum catalysts such as platinum black, platinum chloride, chloroplatinic acid, a platinum-divinylsiloxane catalyst, a platinum-olefin complex, a platinum-carbonyl complex and platinum-acetylacetate; palladium catalysts; rhodium catalysts; and the like.

For the abundance of the catalyst, when the platinum catalyst is used, the platinum content is preferably from 1.0×10⁻⁴ to 0.5 part by weight, and more preferably from 1.0×10⁻³ to 0.05 part by weight, based on 100 parts by weight of the total amount of the alkoxy group-containing vinylsilane and the side chain type methyl hydrogen silicone oil, from the viewpoint of reaction rate.

The compatibilizer may be any as long as it is a solvent which is amphiphilic for the alkoxy group-containing vinylsilane and the side chain type methyl hydrogen silicone oil. Examples thereof include hexane, octane, toluene, xylene and the like, as well as esters such as butyl acetate and ethyl acetate; ether-based solvents such as diethyl ether, dibutyl ether and dioxane; and ketone-based solvents such as acetone, methyl ethyl ketone, methyl isobutyl ketone and cyclohexanone.

The abundance of the compatibilizer is preferably from 50 to 1,000 parts by weight, and more preferably from 100 to 200 parts by weight, based on 100 parts by weight of the total amount of the side chain type methyl hydrogen silicone oil.

As the side chain type methyl hydrogen silicone oil, known one can be used as long as it is a silicone oil having a methyl group and a hydrogen atom on a side chain, and one synthesized according to a known method may be used.

Specifically, for example, a solid acid catalyst such as Amberlyst 15 (manufactured by Sigma-Aldrich Corporation) is added to a mixture of octamethylcyclotetrasiloxane, 1,3,5,7-tetramethylcyclotetrasiloxane and hexamethyldisiloxane, followed by heating at 70°C for 18 hours under a nitrogen stream, and then, the product thus obtained is filtered and concentrated under reduced pressure at 90°C for 3 hours, thereby being able to obtain the silicone oil. Incidentally, the resulting product can be confirmed to be the side chain type methyl hydrogen silicone oil by ¹H-NMR.

The functional group equivalent weight of the side chain type methyl hydrogen silicone oil is preferably from 1 to 30 mmol/g, and more preferably from 3 to 20 mmol/g. Incidentally, in this specification, the functional group equivalent weight of the silanol derivative can be measured by a method described in Examples to be mentioned later.

For the weight ratio of the alkoxy group-containing vinylsilane and the side chain type methyl hydrogen silicone oil, from the viewpoint of reacting the vinyl group of the alkoxy group-containing vinylsilane with the hydrosilyl group of the side chain type methyl hydrogen silicone oil in just proportion, the molar ratio of the above-mentioned functional groups (vinyl group/hydrosilyl group) is preferably from 20/1 to 0.1/1, more preferably from 10/1 to 0.2/1, still more preferably 10/1 to 0.5/1, and yet still more preferably substantially equivalent (1/1).

The reaction of the alkoxy group-containing vinylsilane with the side chain type methyl hydrogen silicone oil can be performed with stirring, preferably at 60 to 100°C, more preferably at 70 to 80°C, preferably for 1 to 8 hours, more preferably for 2 to 4 hours.

The concentration under reduced pressure can be performed according to a known method, preferably at 25 to 80°C, more preferably at 50 to 60°C, preferably for 1 to 8 hours, more preferably for 2 to 4 hours. Further, the concentration under reduced pressure may be performed by dividing into two steps. In that case, the first-step concentration under reduced pressure is preferably performed at 60 to 80°C for 30 to 60 minutes, and the second-step concentration under reduced pressure is preferably performed at 40 to 60°C for 60 to 240 minutes.

Incidentally, the degree of progress of the addition reaction of the vinyl group of the alkoxy group-containing vinylsilane with the hydrosilyl group of the side chain type methyl hydrogen silicone oil can be confirmed by the degree of disappearance of a peak derived from the hydrosilyl group by ¹H-NMR measurement.

In the invention, another silicone derivative other than the compound represented by the above-mentioned formula (I) may be contained within the range not impairing the effects of the invention. The other silicone derivative is not particularly limited, as long as it is condensation reacted with the alkoxy group of the compound represented by formula (I), which is not subjected to the reaction with the metal oxide fine particles, and examples thereof include known silicone derivatives. However, from the viewpoint of inhibiting excessive crosslinking of the resin, trimethylmethoxysilane is preferred. The content of the compound represented by formula (I) in the thermosetting silicone derivative is preferably from 70 to 100% by weight, more preferably from 80 to 100% by weight, and still more preferably from 90 to 100% by weight.

The content of the thermosetting silicone derivative is preferably from 50 to 99% by weight, and more preferably from 60 to 99% by weight, in the composition.

The metal oxide fine particles having reactive functional groups on surfaces thereof include titanium oxide, zirconium oxide, barium titanate, zinc oxide, lead titanate and silicon dioxide, and these may be used either alone or as a combination of two or more thereof. Above all, at least one selected from the group consisting of titanium oxide, zinc oxide, zirconium oxide, barium titanate and silicon dioxide is desirable, from the viewpoint of obtaining a high refractive index. Incidentally, as titanium oxide, there may be used either rutile type titanium dioxide or anatase type titanium oxide.

Examples of the reactive functional groups in the metal oxide fine particles include a hydroxy group, an isocyanate group, an amino group, a mercapto group, a carboxy group, an epoxy group, a vinyl type unsaturated group, a halogen group and an isocyanurate group.

The content of the reactive functional groups on the surfaces of the metal oxide fine particles can be determined from the amount of the fine particles, the surface area of the fine particles, the reaction amount of the surface treating agent, and the like. However, in the invention, fine particles in which the reaction amount thereof with the surface treating agent determined by a method of measuring the content of the reactive functional groups in Example to be mentioned later is 0.1% by weight or more is referred to as the "metal oxide fine particles having reactive functional groups on surfaces thereof'. The reaction amount is taken as the content of the reactive functional groups herein, and the content thereof in the metal oxide fine particles is not particularly limited, as long as it is 0.1% by weight or more. Incidentally, in this specification, the content of the reactive functional groups on the surfaces of the metal oxide fine particles can be measured by the method described in Examples to be mentioned later, and "the content of the reactive functional groups" means "the content" and/or "the abundance" of the reactive functional groups.

Further, the content of the reactive functional groups on the surfaces of the metal oxide fine particles can be decreased, for example, by reacting a solution of methyltrimethoxysilane in an organic solvent with the fine particles. Furthermore, the amount of the reactive functional groups on the surfaces thereof can be decreased by firing the fine particles at high temperature.

As the metal oxide fine particles, there can be used fine particles produced by a known method. Above all, preferred are fine particles obtained by at least one production method selected from the group consisting of a hydrothermal synthesis method, a sol-gel method, a supercritical hydrothermal synthesis method, a coprecipitation method and a homogeneous precipitation method, from the viewpoints of size uniformity of the particles and fine particle size reduction.

In order to inhibit an influence of light scattering of particles in a visible light region (wavelength: 380 to 780 nm), it is preferred that the particles have a particle size of 1/10 or less the wavelength of light. Accordingly, the average particle size of the metal oxide fine particles is preferably from 1 to 100 nm, more preferably from 1 to 70 nm, and still more preferably from 1 to 20 nm. In this specification, the average particle size of the metal oxide fine particles can be measured by particle size measurement of a particle dispersion by a dynamic light scattering method or direct observation under a transmission electron microscope.

The refractive index of the metal oxide fine particles is preferably from 1.4 to 2.7, and more preferably from 2.0 to 2.7, from the viewpoint of improvement of LED light extraction efficiency. In this specification, the refractive index can be measured by a method described in Examples to be mentioned later.

Incidentally, the metal oxide fine particles may be prepared in a dispersion (also referred to as a metal oxide fine particle dispersion), from the viewpoint of inhibiting aggregation. Examples of dispersion media include water, alcohols, ketone-based solvents and acetamide-based solvents, and it is preferred to use water, methanol, butyl methyl ketone or dimethylacetamide. The amount (solid concentration) of the metal oxide fine particles in the dispersion is preferably from 10 to 40% by weight, more preferably from 20 to 40% by weight, and still more preferably from 30 to 40% by weight, from the viewpoint of efficiently performing the reaction at the surfaces of the particles. As such metal oxide fine particle dispersions, there can be used commercially available products such as NEOSUNVEIL or QUEEN TITANIC Series of Catalyst & Chemicals Ind. Co., Ltd. and Tynoc of Taki Chemical Co., Ltd. as titanium oxide; ZSL Series of Daiichi Kigenso Kagaku Kogyo Co., Ltd., NZD Series of Sumitomo Osaka Cement Co., Ltd. and Nano-Use Series ofNissan Chemical Industries, Ltd. as zirconium oxide; and the like.

The content of the metal oxide fine particles is preferably from 1 to 70 parts by weight, more preferably from 1 to 60 parts by weight, and still more preferably from 1 to 40 parts by weight, based on 100 parts by weight of the thermosetting silicone derivative.

The silicone resin composition may contain additives such as an antioxidant, a modifier, a surfactant, a dye, a pigment, a discoloration preventing agent and an ultraviolet absorber, in addition to the above-mentioned thermosetting silicone derivative and metal oxide fine particles, within the range not impairing the effects of the invention.

The silicone resin composition of the invention can be prepared, for example, by adding dropwise a resin solution prepared by dissolving the compound represented by formula (I) in an organic solvent to a liquid obtained by adding an organic solvent to the above-mentioned metal oxide fine particle dispersion, followed by stirring, and mixing the resin solution with the liquid to perform a polymerization reaction, or adding dropwise a liquid obtained by adding an organic solvent to the above-mentioned metal oxide fine particle dispersion, followed by stirring, to a resin solution prepared by dissolving the compound represented by formula (I) in an organic solvent, and mixing the liquid with the resin solution to perform a polymerization reaction, and further, adding dropwise a resin solution prepared by dissolving a thermosetting silicone derivative other than the above in an organic solvent to the resulting polymer and mixing the resin solution with the polymer to perform a polycondensation reaction, as needed. Incidentally, the reaction solution thus obtained may be concentrated under reduced pressure.

As the metal oxide fine particle dispersion, there may be used a dispersion in which the pH is previously adjusted, from the viewpoint of dispersibility of the fine particles. The pH of the metal oxide fine particle dispersion is preferably from 1.0 to 4.0, and more preferably from 2.0 to 3.0.

The organic solvent to be added to the metal oxide fine particle dispersion and the organic solvent to be added to the silicone derivatives (the compound represented by formula (I) and the thermosetting silicone derivative other than the compound represented by formula (I)) are preferably amphiphilic solvents, and specifically, there are exemplified methanol, ethanol, 2-methoxyethanol, 2-propanol, tetrahydrofuran and the like.

When the organic solvent is added to the metal oxide fine particle dispersion, it is desirable to adjust the concentration of the metal oxide fine particles based on the total amount of the organic solvent preferably to 1 to 10% by weight, more preferably to 1 to 2% by weight.

Each silicone derivative is dissolved in the organic solvent preferably to a concentration of 10 to 50% by weight, more preferably to a concentration of 30 to 50% by weight to prepare the resin solution.

The reaction of the compound represented by formula (I) with the metal oxide fine particles can be performed by stirring preferably at 40 to 80°C, more preferably at 50 to 60°C, preferably for 1 to 8 hours, more preferably for 2 to 4 hours.

The temperature at which the thermosetting silicone derivative other than the above is reacted with the reaction product of the compound represented by formula (I) and the metal oxide fine particles is preferably from 40 to 80°C, and more preferably from 50 to 60°C. The reaction time is preferably from 1 to 8 hours, and more preferably from 1 to 4 hours.

The concentration under reduced pressure can be performed according to a known method, preferably at 25 to 80°C, more preferably at 50 to 60°C, preferably for 1 to 8 hours, more preferably for 2 to 4 hours.

The thermosetting silicone resin composition thus obtained is applied, for example, onto a glass substrate by a method such as casting, spin coating or roll coating, and dried by heating at such a temperature that the solvent is removable, thereby being able to form the composition into a sheet form. Accordingly, the invention provides a silicone resin sheet formed by applying the thermosetting silicone resin composition of the invention onto a substrate, followed by drying. As the sheet, one having a thickness of 10 to 1,000 µm is exemplified, and one having a thickness of 100 to 200 µm is preferred. Incidentally, the temperature at which the resin solution is dried is preferably from 80 to 150°C, although it cannot be necessarily determined because it varies depending on the kind of resin or solvent. The drying time is preferably from 5 to 60 minutes, and more preferably from 10 to 20 minutes.

The resin composition of the invention has high light transmitting property because of its excellent transparency. For example, when the resin composition is formed into a sheet having a thickness of 10 to 500 µm, the transmittance to an incident light having a wavelength of 400 to 700 nm is preferably 80% or more, more preferably 82% or more, and still more preferably from 85 to 100%. Incidentally, in this specification, the light transmittance is measured by a method described in Examples to be mentioned later.

Further, the refractive index of the resin composition of the invention is about 0.02 to 0.10 higher than that of a resin composition containing no metal oxide fine particles. For example, when the resin composition is formed into a sheet having a thickness of 10 to 500 µm, the refractive index to an incident light having a wavelength of 400 to less than 550 nm is preferably from 1.43 to 1.53, more preferably from 1.47 to 1.53, and still more preferably from 1.51 to 1.53, and the refractive index to an incident light having a wavelength of 550 to 700 nm is preferably from 1.43 to 1.52, more preferably from 1.46 to 1.52, and still more preferably from 1.50 to 1.52. Thus, a high refractive index is shown even at a high wavelength.

A preferred method for producing the silicone resin composition of the invention is a method including a step (step (1)) of polymerizing the compound represented by formula (1) with the metal oxide fine particles.

Specific examples of step (1) include, for example, a step of adding dropwise a resin solution prepared by dissolving the compound represented by formula (I) in an organic solvent such as methanol, ethanol, 2-methoxyethanol, 2-propanol or tetrahydrofuran preferably to a concentration of 40 to 60% by weight, to a liquid prepared to a metal oxide fine particle concentration of 1 to 10% by weight by adding an organic solvent such as methanol, ethanol, 2-methoxyethanol, 2-propanol or tetrahydrofuran to the metal oxide fine particle dispersion, followed by stirring; mixing the resin solution with the liquid; and performing a reaction preferably at 40 to 80°C, more preferably at 50 to 60°C, preferably for 1 to 8 hours, more preferably for 2 to 4 hours.

Further, from the viewpoint of adjusting the crosslinking degree of the silicone resin composition of the invention, the preferred method for producing the silicone resin composition of the invention may includes a step (step (2)) of performing a polycondensation reaction of the thermosetting silicone resin composition other than the compound represented by formula (I) with the reaction product obtained in step (1).

Specific examples of step (2) include, for example, a step of adding dropwise a resin solution prepared by dissolving the thermosetting silicone resin composition other than the compound represented by formula (I), for example, trimethylmethoxysilane, in an organic solvent such as methanol, ethanol, 2-methoxyethanol, 2-propanol or tetrahydrofuran preferably to a concentration of 40 to 60% by weight, to the reaction product obtained in step (1); mixing the resin solution with the reaction product; and performing a reaction preferably at 40 to 80°C, more preferably at 50 to 60°C, preferably for 1 to 8 hours, more preferably for 1 to 4 hours.

Incidentally, the resulting reaction solution is subjected to a step of removing the solvent by distillation under reduced pressure to perform concentration, thereby being able to adjust the concentration and viscosity.

The silicone resin composition thus obtained is excellent in transparency, light transmitting property and heat resistance and has a high refractive index, so that the resin composition can be suitably used, for example, as an optical semiconductor element-encapsulating material used in optical semiconductor devices mounted with blue or white LED elements (backlights of liquid crystal screens, traffic signals, outdoor large-sized displays, advertisement sign boards and the like). Accordingly, the invention also provides an optical semiconductor device in which an optical semiconductor element is encapsulated by using the above-mentioned silicone resin composition.

The optical semiconductor device of the invention can be produced by encapsulating LED elements by using the silicone resin composition of the invention as the optical semiconductor element-encapsulating material. Specifically, the optical semiconductor device can be produced by applying the silicone resin composition of the invention as it is onto a substrate mounted with the LED elements to an appropriate thickness by a method such as casting, spin coating or roll coating, followed by heating and drying.

### EXAMPLES

The invention will be described below with reference to examples, but the invention is not construed as being limited thereto.

### Molecular Weight of Silicone Derivative

The molecular weight is determined in terms of polystyrene by gel permeation chromatography (GPC).

### Alkoxy Group Content of Silicone Derivative

The alkoxy group content is calculated from quantitative determination by ¹H-NMR using an internal standard substance and the value of the weight decrease by differential thermogravimetric analysis.

### Functional Group Equivalent Weight of Silicone Derivative

The functional group equivalent weight is measured by ¹H-NMR using an internal standard substance.

### Average Particle Size of Metal Oxide Fine particles

In this specification, the average particle size of the metal oxide fine particles means the average particle size of primary particles, and means 50% volume cumulative diameter (D₅₀) measured for a particle dispersion of the metal oxide fine particles by a dynamic light scattering method and calculated.

### Content of Reactive Functional Groups on Surfaces of Metal Oxide Fine particles

Ethyltrimethoxysilane is added as a surface treating agent to a fine particle dispersion to perform a reaction, the fine particles are aggregated and sedimented by centrifugation or changes on pH, followed by separation by filtration, collecting, washing and drying, the weight decrease is determined by differential thermogravimetric analysis, and the content is calculated therefrom.

### Refractive Index of Metal Oxide Fine particles

The refractive index at 25°C and 633 nm is measured by using a prism coupler (SPA-4000, manufactured by Sairon Technology, Inc.). Incidentally, an aqueous dispersion of the metal oxide fine particles is used as a sample liquid for measurement.

### Light transmitting property of Silicone Resin Composition

The transmission spectrum in a visible light region of 400 to 800 nm is measured by using a spectrophotometer (U-4100, manufactured by Hitachi High-Technologies Corporation), and the transmittance at 400 nm is calculated.

### Synthesis Example 1 of Compounds Represented by Formula (I)

A mixture of an alkoxy group-containing vinylsilane, a compatibilizer and a platinum catalyst shown in Table 1 was heated at 80°C, and a side chain type methyl hydrogen silicone oil is gradually added dropwise thereto under a nitrogen steam. After the addition was terminated, stirring was further continued at 80°C for 4 hours. The resulting mixture was concentrated under reduced pressure at 80°C for 30 minutes, subsequently at 60°C for 4 hours to obtain each of transparent and colorless alkoxy group-containing polymethylsiloxanes A to E.

### Synthesis Example 2 of Compound Represented by Formula (I)

A mixture of 14.0 g of octamethylcyclotetrasiloxane, 7.6 g of 1,3,5,7-tetramethylcyclotetrasiloxane (trade name: "LS-8600", manufactured by Shin-Etsu Chemical Co., Ltd.), 0.3 g of hexamethyldisiloxane (trade name: "LS-7130", manufactured by Shin-Etsu Chemical Co., Ltd.) and 4.4 g of Amberlyst 15 (manufactured by Sigma-Aldrich Corporation) was heated at 70°C for 18 hours under a nitrogen stream, and thereafter, the product was filtered and concentrated under reduced pressure at 90°C for 3 hours to obtain a side chain type methyl hydrogen silicone oil (silicone oil A). The functional group equivalent weight thereof was 4.5 mmol/g. Incidentally, the resulting product (silicone oil A) was confirmed to be the side chain type methyl hydrogen silicone oil by ¹H-NMR.

The resulting side chain type methyl hydrogen silicone oil (silicone oil A) (5.8 g) was gradually added dropwise to a mixture of an alkoxy group-containing vinylsilane, a compatibilizer and a platinum catalyst shown in Table 1, which was heated at 80°C. After the addition was terminated, stirring was further continued at 80°C for 3 hours to obtain transparent and colorless alkoxy group-containing polymethylsiloxane F. Incidentally, the compatibilizer remains in the resulting alkoxy group-containing polymethylsiloxane F, so that the silicone derivative concentration is about 80% by weight.

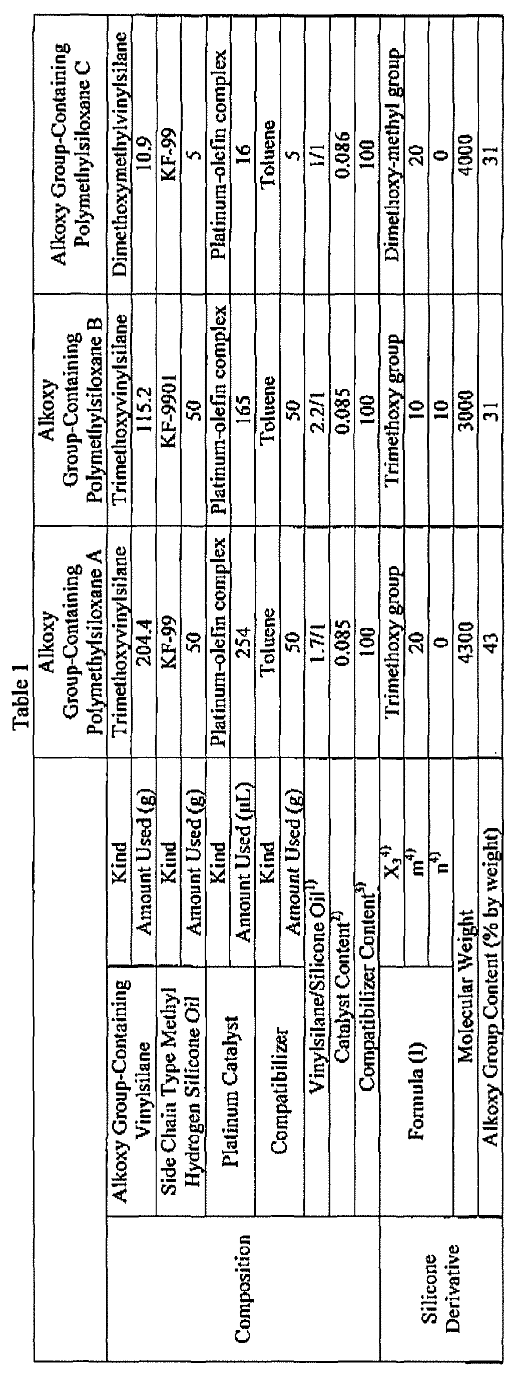

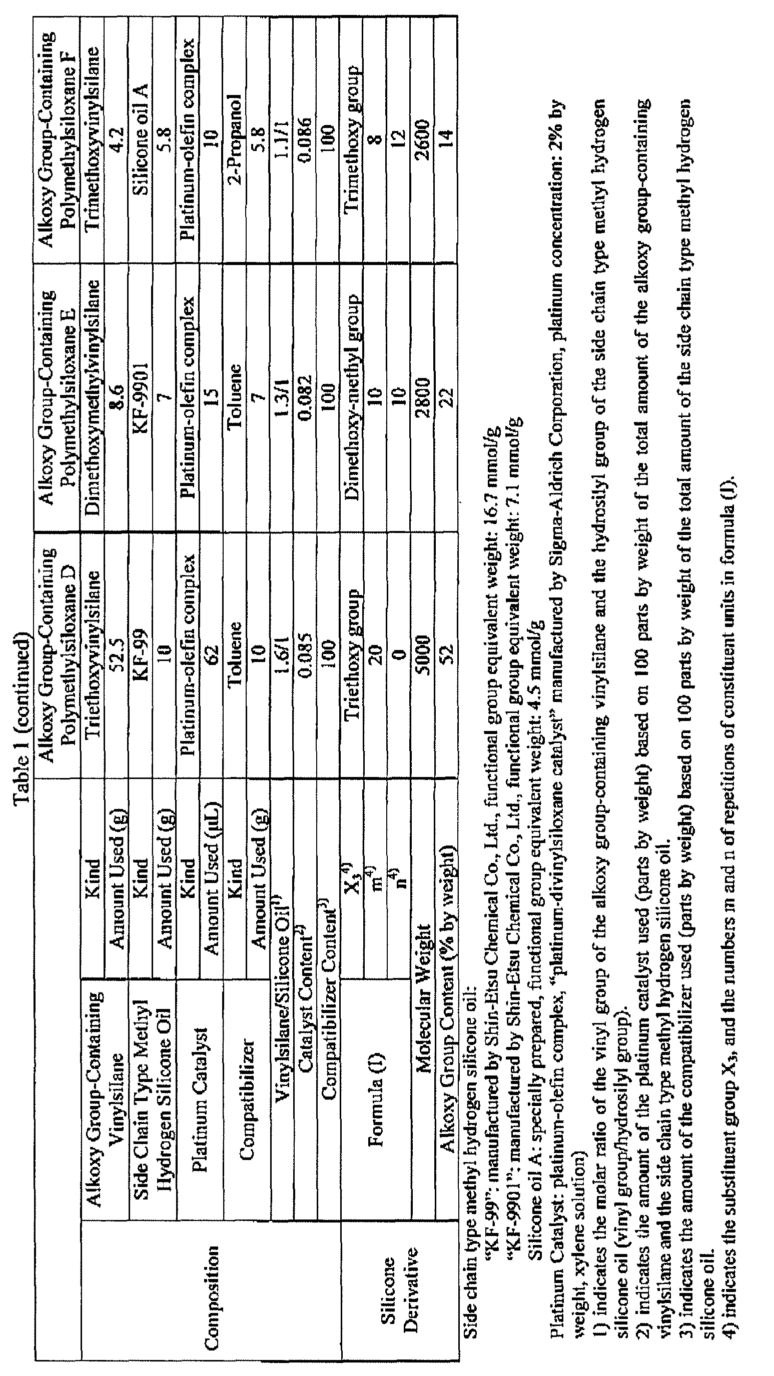

### Example 1

In a container equipped with a stirrer, a reflux condenser, and a nitrogen inlet tube, a mixture (metal oxide fine particle concentration: 2% by weight) of 9.23 g of a zirconium oxide-dispersed pH-adjusted liquid in which an aqueous dispersion of zirconium oxide having an average particle size of 7 nm ("NZD-3007-NDO", manufactured by Sumitomo Osaka Cement Co., Ltd., solid concentration: 40% by weight, containing a hydroxyl group as a reactive functional group, reactive functional group content: 0.1 % by weight, refractive index: 2.1) was adjusted to pH 2.0 to 3.0 (the content of zirconium oxide was 34 parts by weight based on 100 parts by weight of the total amount of the silicone derivatives, that is to say, 100 parts by weight of the compound represented by formula (I) and the compound other than the compound represented by formula (I)), 87 g of methanol and 87 g of 2-methoxyethanol was added dropwise to a solution (silicone derivative concentration: 50% by weight) in which 10 g of alkoxy group-containing polymethylsiloxane A was dissolved as the compound represented by formula (I) in 10 g of 2-propanol, which was heated at 60°C, at a rate of a drop per second using a dropping funnel, After the addition was terminated, stirring was further continued at 60°C for 3 hours to perform a reaction. A solution (silicone derivative concentration: 50% by weight) in which 1 g of trimethylmethoxysilane was dissolved as the compound other than the compound represented by formula (I) in 1 g of 2-propanol was further added dropwise thereto at a rate of a drop.per second using a dropping funnel. After the addition was terminated, stirring was further continued at 60°C for 1 hour to perform a reaction, thus obtaining a silicone resin composition.

### Example 2

A silicone resin composition was obtained in the same manner as in Example 1 with the exception that 10 g of alkoxy group-containing polymethylsiloxane B was used in place of 10 g of alkoxy group-containing polymethylsiloxane A.

### Example 3

A silicone resin composition was obtained in the same manner as in Example 1 with the exception that a mixture (metal oxide fine particle concentration: 2% by weight) of 1.24 g of a zirconium oxide-dispersed pH-adjusted liquid (the content of zirconium oxide was 5 parts by weight based on 100 parts by weight of the total amount of the silicone derivatives), 12 g of methanol and 12 g of 2-methoxyethanol was used in place of the mixture of 9.23 g of the zirconium oxide-dispersed pH-adjusted liquid, 87 g of methanol and 87 g of 2-methoxyethanol.

### Example 4

A silicone resin composition was obtained in the same manner as in Example 3 with the exception that 10 g of alkoxy group-containing polymethylsiloxane C was used in place of 10 g of alkoxy group-containing polymethylsiloxane A.

### Example 5

A silicone resin composition was obtained in the same manner as in Example 3 with the exception that 10 g of alkoxy group-containing polymethylsiloxane D was used in place of 10 g of alkoxy group-containing polymethylsiloxane A.

### Example 6

A silicone resin composition was obtained in the same manner as in Example 2 with the exception that a mixture (metal oxide fine particle concentration: 2% by weight) of 1.24 g of a zirconium oxide-dispersed pH-adjusted liquid (the content of zirconium oxide was 5 parts by weight based on 100 parts by weight of the total amount of the silicone derivatives), 12 g of methanol and 12 g of 2-methoxyethanol was used in place of the mixture of 9.23 g of the zirconium oxide-dispersed pH-adjusted liquid, 87 g of methanol and 87 g of 2-methoxyethanol.

### Example 7

A silicone resin composition was obtained in the same manner as in Example 3 with the exception that 10 g of alkoxy group-containing polymethylsiloxane E was used in place of 10 g of alkoxy group-containing polymethylsiloxane A.

### Example 8

In a container equipped with a stirrer, a reflux condenser, and a nitrogen inlet tube, a mixture (metal oxide fine particle concentration: 2% by weight) of 1.24 g of a zirconium oxide-dispersed pH-adjusted liquid (the content of zirconium oxide was 5 parts by weight based on 100 parts by weight of the total amount of the silicone derivatives), 12 g of methanol and 12 g of 2-methoxyethanol was added dropwise to a mixture (silicone derivative concentration: 65% by weight) of 10 g of alkoxy group-containing polymethylsiloxane F as the compound represented by formula (I), from which the solvent was not removed by distillation, and 2 g of 2-propanol, at a rate of a drop per second using a dropping funnel. After the addition was terminated, stirring was further continued at 60°C for 3 hours to perform a reaction. A solution (silicone derivative concentration: 50% by weight) in which 1 g of trimethylmethoxysilane was dissolved as the compound other than the compound represented by formula (I) in 1 g of 2-propanol was further added dropwise thereto at a rate of a drop per second using a dropping funnel. After the addition was terminated, stirring was further continued at 60°C for 1 hour to perform a reaction, thus obtaining a silicone resin composition.

### Example 9

A silicone resin composition was obtained in the same manner as in Example 1 with the exception that trimethylmethoxysilane was not used. Incidentally, the content of zirconium oxide was 37 parts by weight based on 100 parts of the total amount of the silicone derivative, that is to say, 100 parts by weight of the compound represented by formula (I).

### Comparative Example 1

A silicone resin composition was obtained in the same manner as in Example 1 with the exception that a mixture of 1.24 g of a hydrochloric acid-diluted liquid (pH: 2.0 to 3.0),12 g of methanol and 12 g of 2-methoxyethanal was used in place of the mixture of 9.23 g of the zirconium oxide-dispersed pH-adjusted liquid, 87 g of methanol and 87 g of 2-methaxyethanal.

### Comparative Example 2

A silicone resin composition was obtained in the same manner as in Example 2 with the exception that a mixture of 1.24 g of a hydrochloric acid-diluted liquid (pH: 2.0 to 3.0), 12 g of methanol and 12 g of 2-methoxyethanol was used in place of the mixture of 9.23 g of the zirconium oxide-dispersed pH-adjusted liquid, 87 g of methanol and 87 g of 2-methoxyethanol.

### Comparative Example 3

A silicone resin composition was obtained in the same manner as in Example 8 with the exception that a mixture of 1.24 g of a hydrochloric acid-diluted liquid (pH: 2.0 to 3.0), 12 g of methanol and 12 g of 2-methoxyethanol was used in place of the mixture of 9.23 g of the zirconium oxide-dispersed pH-adjusted liquid, 87 g of methanol and 87 g of 2-methoxyethanol.

### Comparative Example 4

A silicone resin composition was obtained in the same manner as in Example 1 with the exceptions that 10 g of a silicone derivative (manufactured by Shin-Etsu Chemical Co., Ltd., trade name: "X-21-5841", a silanol, functional group equivalent weight: 500 g/mol) was used in place of 10 g of alkoxy group-containing polymethylsiloxane A, and that trimethylmethoxysilane was not used. Incidentally, the content of zirconium oxide was 37 parts by weight based on 100 parts of the total amount of the silicone derivative, that is to say, 100 parts by weight of the silicone derivative (X-21-5841).

### Comparative Example 5

Ethanol (10 g) was added to 9.23 g of the zirconium oxide-dispersed pH-adjusted liquid (NZD-3007-NDO) adjusted to pH 2.0 to 3.0, and a mixture of 8 g of a silane coupling agent (manufactured by Shin-Etsu Chemical Co., Ltd., trade name: "KBM-3103", decyltrimethoxysilane) and 2 g of 2-propanol was added thereto, followed by stirring at room temperature (25°C) for 3 hours. The resulting solution was centrifuged at 1,000 r/min for 10 minutes, and a precipitate was collected. Thereafter, 10 g of 2-propanol was added to the precipitate, followed by centrifugation at 1,000 r/min for 10 minutes again, and the precipitate was collected. Then, 4 g of the resulting precipitate was dissolved in 10 g of toluene to obtain a surface-modified zirconium oxide dispersion.

Then, a silicone resin composition was obtained in the same manner as in Example 1 with the exceptions that 14 g of the surface-modified zirconium oxide dispersion prepared above was used in place of 9.23 g of the zirconium oxide-dispersed pH-adjusted liquid, and that trimethylmethoxysilane was not used. Incidentally, the content of zirconium oxide was 30 parts by weight based on 100 parts of the total amount of the silicone derivative, that is to say, 100 parts by weight of the compound represented by formula (I).

### Preparation of Sheets

Using the compositions obtained above, sheets were prepared. Specifically, each of the above-mentioned compositions was applied onto a glass plate to a thickness of 100 to 200 µm, followed by heating at 150°C for 10 minutes to prepare each of semi-cured products (sheets) of the compositions.

For the sheets obtained, characteristics were evaluated according to the following Test Examples 1 to 4. The results thereof are shown in Table 2.

### Test Example 1 (Transparency)

The haze at the time when each sheet was irradiated with a D65 light was measured by using a haze meter (HR-100, manufactured by Murakami Color Research Laboratory) according to JIS 7105. Lower haze shows higher transparency.

### Test Example 2 (Light transmitting property)

The light transmittance (%) of each sheet at a wavelength of 450 nm was measured by using a spectrophotometer (U-4100, manufactured by Hitachi High-Technologies Corporation). Higher light transmittance shows higher light transmitting property.

### Test Example 3 (Heat Resistance)

Each sheet was allowed to stand still in a hot air dryer of 150°C, and the appearance of the sheet after an elapse of 15 hours was visually observed. The case where there was no change from a state before storage in the appearance of the sheet was evaluated as "A", and the case where there was a change was evaluated as "B". The case where no change is observed in the appearance of the sheet after storage shows that the sheet is excellent in heat resistance.

### Test Example 4 (Refractive Index)

The refractive indexes (%) at wavelengths of 533 nm and 632.8 nm were measured by using a prism coupler (SPA-4000, manufactured by Sairon Technology, Inc.). A higher refractive index can be evaluated to have a higher refractive index, and it is preferred that both refractive indexes are high.

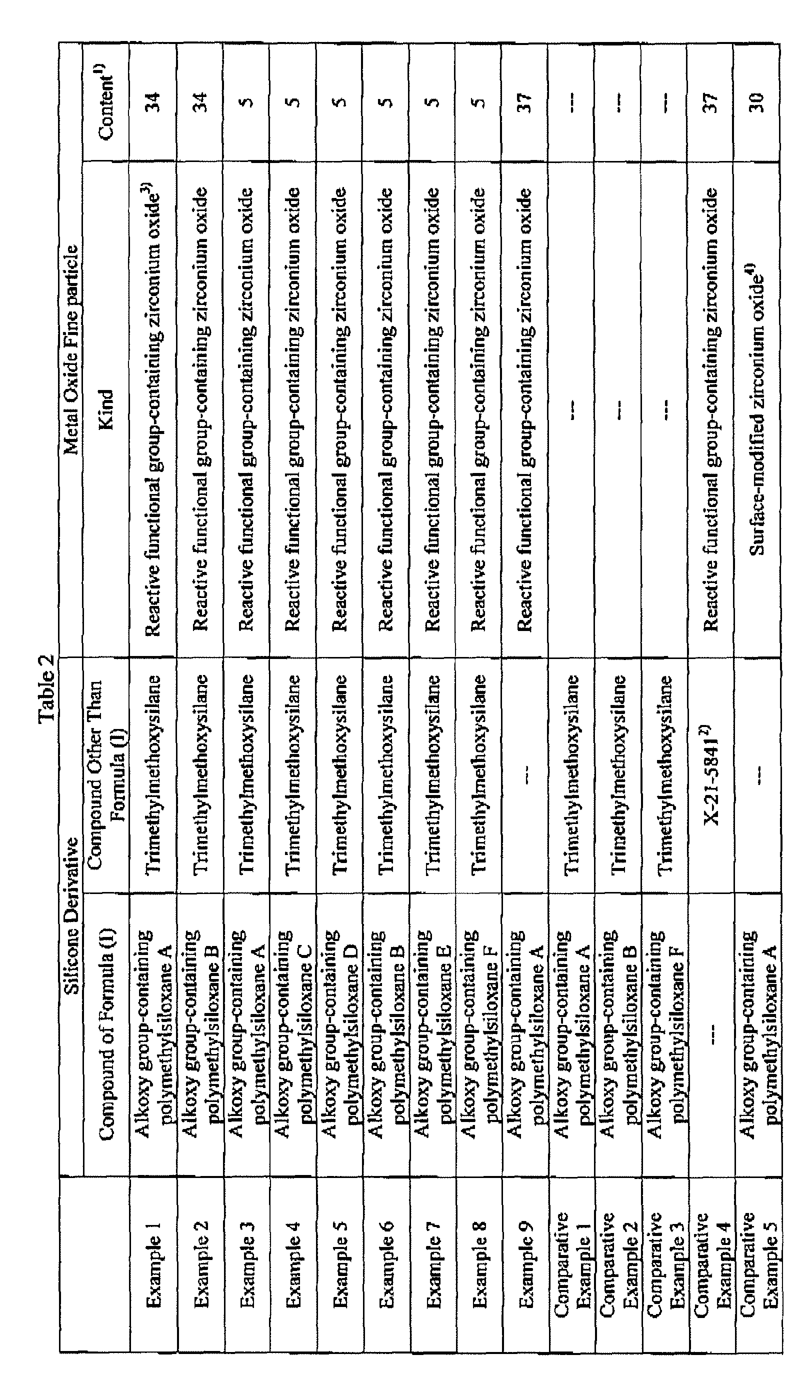

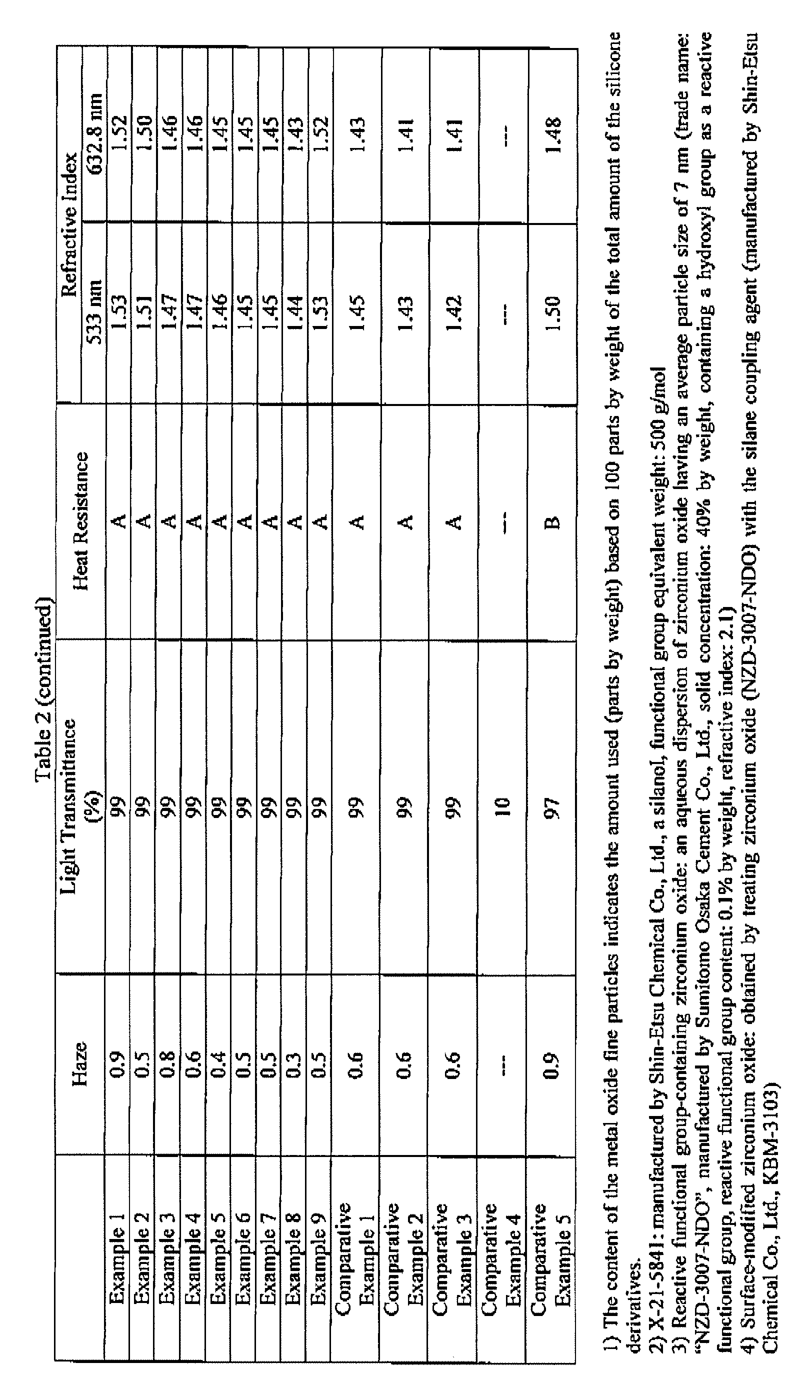

The results show that the compositions of Examples are excellent in transparency, light transmitting property and heat resistance, and have a high refractive index, compared to the compositions of Comparative Examples. Incidentally, for the composition of Comparative Example 4, the characteristics other than the light transmittance could not be evaluated because white turbidity occurred when the silicone derivative was reacted with the metal oxide fine particles. This is considered to be caused by the occurrence of aggregation of the metal oxide fine particles because reactivity between the silicone derivative and the metal oxide fine particles is low. Further, the composition of Comparative Example 5 is well dispersed because the metal oxide fine particles are surface modified with the silane coupling agent, but it is conceivable that the composition is poor in heat resistance because the silane coupling agent has many reactive functional groups.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2009-091243 filed on April 3, 2009, and the contents are incorporated herein by reference.
Also, all the references cited herein are incorporated as a whole.

The metal oxide fine particle-containing silicone resin composition of the invention is suitably used, for example, when producing semiconductor elements for backlights of liquid crystal screens, traffic signals, outdoor large-sized displays, advertisement sign boards and the like.

## Claims

1. A metal oxide fine particle-containing silicone resin composition obtained by polymerizing a thermosetting silicone derivative with metal oxide fine particles having reactive functional groups on surfaces thereof, wherein the thermosetting silicone derivative contains a compound represented by formula (I): 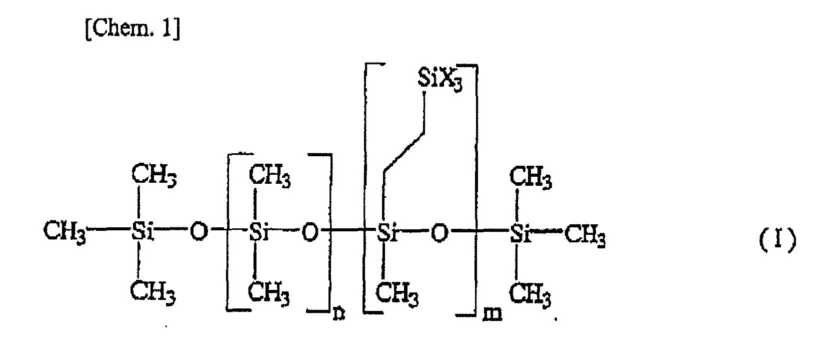 wherein X's each independently represent an alkoxy group or an alkyl group, m represents an integer of 1 or more, and n represents an integer of 0 or 1 or more, provided that at least one of 3m X's is an alkoxy group.

2. The metal oxide fine particle-containing silicone resin composition according to claim 1, wherein the metal oxide fine particles have an average particle size of 1 to 100 nm.

3. A method for producing a metal oxide fine particle-containing silicone resin composition, said method comprising a step of polymerizing a thermosetting silicone derivative with metal oxide fine particles having reactive functional groups on surfaces thereof, wherein the thermosetting silicone derivative contains a compound represented by formula (I): 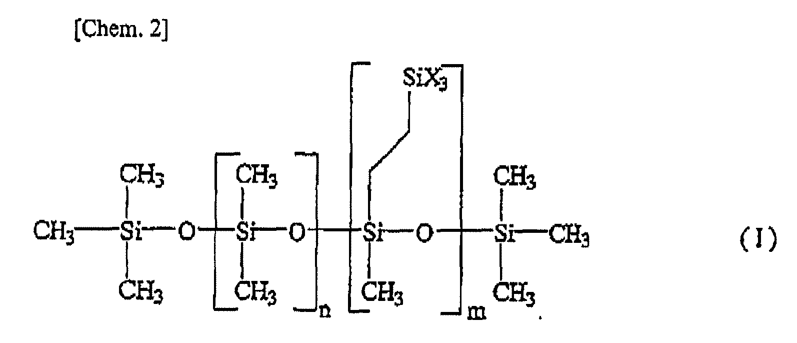 wherein X's each independently represent an alkoxy group or an alkyl group, m represents an integer of 1 or more, and n represents an integer of 0 or 1 or more, provided that at least one of 3m X's is an alkoxy group.

4. A silicone resin sheet formed by applying the metal oxide fine particle-containing silicone resin composition according to claim 1 or 2 onto a substrate, followed by drying.

5. An optical semiconductor device in which an optical semiconductor element is encapsulated by the metal oxide fine particle-containing silicone resin composition according to claim 1 or 2 or the silicone resin sheet according to claim 4.
